# DEMANDE DE BREVET EUROPEEN

(11) **EP 0 549 527 A1**
(43) Date de publication de la demande: **30.06.1993**
(21) Numéro de dépôt: 92810976.8
(22) Date de dépôt: 10.12.1992
(51) Int. Cl.: H01R 9/09, H01R 13/04

(54) **Pièce de contact**

(30) Priorité: 20.12.1991 CH 3825/91
(71) Demandeur: ROBINSON NUGENT SA, CH-2800 Delémont (CH)
(72) Inventeur: Gillam, Paul T., CH-2853 Courfaivre (CH); Marc, Christian, CH-2856 Boécourt (CH)
(74) Mandataire: Fischer, Franz Josef

(57) **Abrégé**

La pièce de contact comportant en particulier une portion de contact (1) et une portion d'insertion (2) est obtenue par décolletage puis fraisage de parties (20B,21,22B,23B) de sa portion d'insertion. Les surfaces d'appui (20A) de la portion d'insertion, destinées à assurer la fixation mécanique ainsi que le contact électrique contre la surface métallisée d'un trou d'une plaque de circuit imprimé, ne présentent aucune aspérité ou décrochement brusque qui pourrait blesser la métallisation du trou en cas de multiples opérations d'insertion/retrait.

Diverses formes d'exécution sont décrites, les différences entre elles provenant du mode d'action des moyens élastiques de fixation de la portion d'insertion, respectivement de leur mode de fabrication.

## Description

La présente invention concerne une pièce de contact destinée à être insérée dans une plaque de circuit imprimé, obtenue par fraisage d'une ébauche obtenue par décolletage.

Ces pièces de contact assurent la transition électrique et mécanique entre un élément électrique ou électronique quelconque et une plaque de circuit imprimé, cet élément pouvant être par exemple un circuit intégré, un composant électrique ou électronique discret ou même une autre plaque de circuit imprimé. Dans de nombreuses applications il n'est pas souhaité ou pas possible que les pièces de contact formant entre elles un connecteur soient fixées par soudage sur une plaque de circuit imprimé; une parmi les solutions adoptées consiste alors à prévoir des moyens de fixation mécaniques de la pièce de contact dans un trou métallisé de la plaque de circuit imprimé. Des normes existent définissant ce type de moyens de fixation ainsi que les exigences auxquelles ils doivent répondre afin d'assurer une liaison mécanique et électrique fiable entre la pièce de contact, respectivement le contact de l'élément qui lui est associé, et le trou métallisé, respectivement la piste métallisée qui lui est associée et qui est disposée sur la plaque de circuit imprimé. En particulier les normes ci-dessus indiquent entre autres exigences, une force maximum d'insertion de la pièce de contact dans le trou métallisé, une force minimum pour l'en retirer, la nécessité de pouvoir insérer et retirer une pièce de contact d'un trou métallisé sans endommagement ni de la pièce de contact, ni du trou métallisé et ceci un certain nombre de fois. Cette dernière exigence est généralement assez difficile à atteindre vu la faible épaisseur de métal déposée sur la paroi latérale du trou, les moyens de fixation utilisés dans l'art antérieur ayant parfois tendance à arracher cette couche de métal.

On peut obtenir des pièces de contact par une simple opération d'étampage, éventuellement précédée ou suivie d'une autre opération d'usinage. Vu la méthode de fabrication, les pièces obtenues de cette manière ne présentent généralement pas une collerette d'appui en forme de tronc de cône nécessaire au centrage de la pièce de contact dans le trou métallisé ainsi qu'à l'étanchéification de ce trou et nécessitent un outillage d'usinage initial coûteux.

Une autre pièce de contact obtenue essentiellement par fraisage et perçage est décrite dans le brevet US-A-4.799.904. La partie d'insertion ou de fixation de la pièce de contact décrite dans ce brevet est constituée d'une pluralité de segments tronconiques successifs orientés de manière à retenir la pièce de contact à l'intérieur du trou métallisé à la manière d'une pointe de harpon. Un évidement central axial le long de cette partie d'insertion, complété d'une fente radiale augmente l'élasticité des moyens de fixation. Une pièce de contact selon cette forme d'exécution de l'art antérieur comporte un certain nombre d'inconvénients; tout d'abord de par la forme des segments tronconiques, ceux-ci ont tendance à s'incruster dans la couche métallisée du trou, assurant il est vrai un bon contact électrique, mais ayant tendance à arracher ou pour le moins à peler cette couche métallisée lors d'un éventuel retrait de la pièce de contact hors du trou métallisé, de plus, vu la forme transversale en U de la partie d'insertion, l'élasticité de cette partie n'est pas bien maîtrisée et a tendance à diminuer après plusieurs insertions/retraits ou suite à un quelconque endommagement de la pièce. Une pièce de contact comportant une partie d'insertion telle que celle-ci est certainement très bien adaptée pour un emploi unique, c'est-à-dire une seule insertion, sans retrait, mais devient assez peu fiable après un retrait. De plus, la fabrication d'une partie d'insertion comme décrite est compliquée, nécessitant plusieurs opérations d'usinage de précision, rendant de ce fait le prix de la pièce de contact relativement élevé.

L'objet de l'invention est donc de proposer une pièce de contact répondant entièrement aux exigences des normes citées, pouvant être insérée et retirée de multiples fois sans perdre ses qualités de fixation mécanique et de conduction électrique et sans endommagement ni du trou métallisé, ni de la pièce elle-même, et dont le coût de fabrication reste aussi bas que possible.

De plus, les moyens de fixation de la pièce de contact selon l'invention doivent pouvoir s'adapter à des pièces de contact comportant un contact mâle ou un contact femelle, à des pièces de contact individuelles disposées chacune dans un trou métallisé afin de former un connecteur, ainsi qu'à des pièces de contact déjà assemblées afin de former un socle ou un connecteur de type quelconque.

Afin d'atteindre les buts fixés, la pièce de contact selon l'invention répond aux caractéristiques des revendications.

Pour mieux comprendre comment la pièce de contact selon l'invention est constituée, on peut se référer au dessin en annexe représentant différentes formes d'exécution d'une pièce de contact, la différence entre ces diverses formes d'exécution provenant essentiellement de la constitution, respectivement du mode d'action des moyens élastiques de fixation de la portion d'insertion dans le trou métallisé, avec les figures où:
- la figure 1A représente une vue en élévation d'une première forme d'exécution de la pièce de contact selon l'invention,
- la figure 1B représente une coupe transversale selon la ligne I-I de la figure précédente,
- la figure 2A représente une vue en élévation d'une deuxième forme d'exécution de la pièce de contact selon l'invention,
- la figure 2B représente une coupe transversale selon la ligne II-II de la figure précédente,
- la figure 3A représente une vue en élévation d'une troisième forme d'exécution de la pièce de contact selon l'invention,
- la figure 3B représente une coupe transversale selon la ligne III-III de la figure précédente,
- la figure 4A représente une vue en élévation d'une quatrième forme d'exécution de la pièce de contact selon l'invention, et
- la figure 4B représente une coupe transversale selon la ligne IV-IV de la figure précédente.

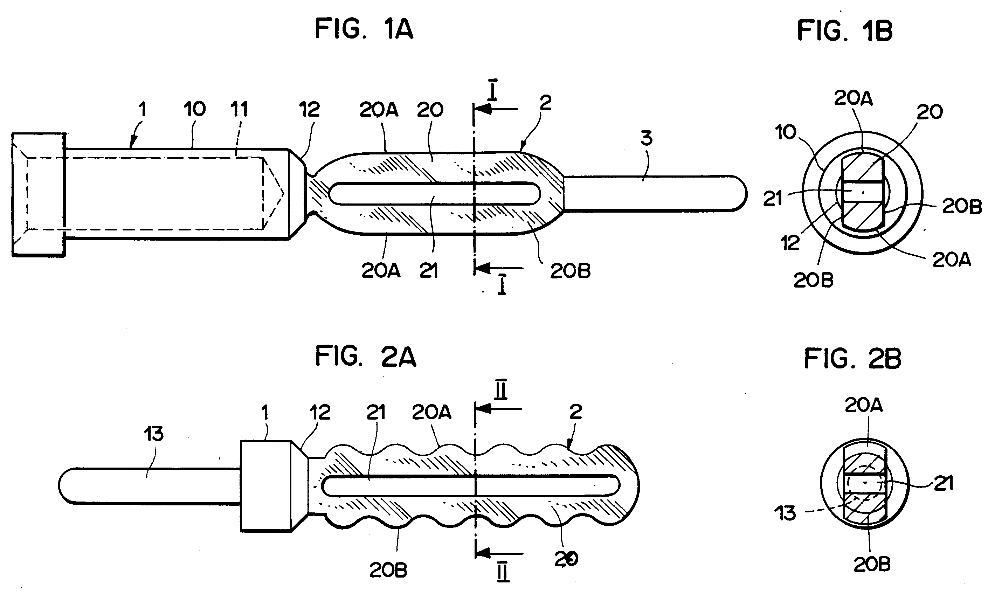

La pièce de contact représentée aux figures 1A et 1B est constituée d'une portion de contact 1, d'une portion d'insertion 2 et éventuellement d'une portion d'extrémité 3. La portion de contact 1 peut être de n'importe quel type connu de la technique, par exemple comme représenté ici une portion de contact de type femelle, c'est-à-dire constituée d'une portion cylindrique 10 à l'intérieur de laquelle est percé un logement 11 destiné à recevoir un contact mâle de l'élément électronique qui y sera connecté. Généralement le contact mâle est retenu à l'intérieur du logement 11 par un ressort, non représenté sur la figure. L'extrémité de la portion cylindrique 10 proche de la portion d'insertion 2 présente avantageusement une portion en tronc de cône 12, permettant de centrer la pièce de contact à l'intérieur du trou métallisé et assurant une étanchéité dudit trou métallisé. Le diamètre extérieur de la portion cylindrique 10, respectivement le diamètre maximum de la portion en tronc de cône 12 est généralement mais non nécessairement supérieur au diamètre du trou métallisé, alors que le diamètre minimum de la portion en tronc de cône est inférieur audit diamètre du trou métallisé. La portion d'insertion 2 selon cette première forme d'exécution de la pièce de contact selon l'invention est constituée ici d'un barreau 20 de section approximativement rectangulaire présentant deux faces d'appui 20A de forme semi-cylindrique et deux faces latérales 20B de préférence mais non nécessairement parallèles. Une fente traversante 21, dont la longueur est inférieure à celle de la portion d'insertion 2, est aménagée à l'intérieur du barreau afin de lui donner une certaine élasticité par la création de deux cols de cygne aux deux extrémités de la fente 21. Si la partie centrale de la longueur du barreau 20 est rectiligne, les deux parties d'extrémité de ce barreau présentent de préférence des arrondis, le premier pour rejoindre le diamètre inférieur de la portion en tronc de cône 12 et le second pour rejoindre le diamètre de la portion d'extrémité 3, la forme desdits arrondis étant déterminée afin d'assurer aussi bien la solidité de la portion d'insertion que son élasticité. Cette portion d'extrémité 3 est aussi de technique connue, elle peut exister ou non. L'usinage de la pièce de contact selon cette forme d'exécution se fait tout d'abord par décolletage de la portion de contact 1 y compris la portion en tronc de cône 12, du profil extérieur de la portion d'insertion 2, correspondant aux surfaces d'appui 20A, la partie centrale de ladite portion ayant un diamètre légèrement plus grand que celui du trou métallisé maximum dans lequel elle sera insérée, puis de l'éventuelle portion d'extrémité 3. Cette opération est suivie d'un fraisage des deux faces latérales 20B du barreau 20, ainsi que de la fente 21. En dimensionnant judicieusement le barreau 20, soit le diamètre de sa portion centrale, son épaisseur, respectivement la largeur des surfaces d'appui 20A et la largeur ainsi que la longueur de la fente 21, il est possible d'ajuster exactement l'élasticité de la portion d'insertion 2, respectivement la pression de contact des faces d'appui 20A contre la surface intérieure du trou métallisé. Vu que les surfaces d'appui 20A ne présentent aucune aspérité ni décrochement brusque, mais que au contraire leurs extrémités se terminent par des arrondis de raccordement, l'insertion et le retrait de la pièce de contact présentant une portion d'insertion selon cette forme d'exécution de l'invention ne peut blesser ou peler la couche métallisée du trou. La portion d'insertion 2 peut donc se déformer élastiquement lors de son insertion dans un trou métallisé, sans destruction, afin de s'adapter au diamètre intérieur dudit trou, lors de son retrait elle reprend sa forme initiale.

La portion de contact 1 de la pièce de contact représentée aux figures 2A et 2B peut aussi être de n'importe quel type connu, comme par exemple comme représenté ici, de type mâle et présentant un embout mâle 13. Comme précédemment, cette portion 1 se termine par une portion en tronc de cône 12 pour les mêmes raisons qu'expliqué plus haut. Le barreau 20 de la portion d'insertion 2 est assez semblable à celui vu plus haut, si ce n'est que sa partie centrale n'est pas rectiligne mais présente plusieurs ondulations (six sur la figure). Une fente 21 est aménagée dans le barreau 20 de la même manière que précédemment. La présences des ondulations sur la partie centrale du barreau augmente l'élasticité de la portion d'insertion 2, créant même une élasticité longitudinale, de par la présence des zones à faible résistance correspondant aux creux des ondulations, ce qui améliore encore le maintien de la pièce à l'intérieur du trou métallisé. La pièce représenté ici ne présente pas de portion d'extrémité 3. Son usinage est assez semblable à celui de la pièce précédente, un décolletage de la portion de contact 1, de la portion en tronc de cône 12, de la portion d'insertion 2, en prévoyant éventuellement un nombre d'ondulations qui est fonction de la longueur de cette portion, respectivement de l'épaisseur de la plaque de circuit imprimé dans lequel elle sera insérée, puis d'opérations de fraisage pour obtenir les faces latérales 20B ainsi que la fente traversante 21, semblable à celle décrite plus haut. Comme précédemment, le diamètre de décolletage au sommet des ondulations, respectivement la hauteur crêté-à-crêté des ondulations, est légèrement plus grande que le diamètre du trou métallisé.

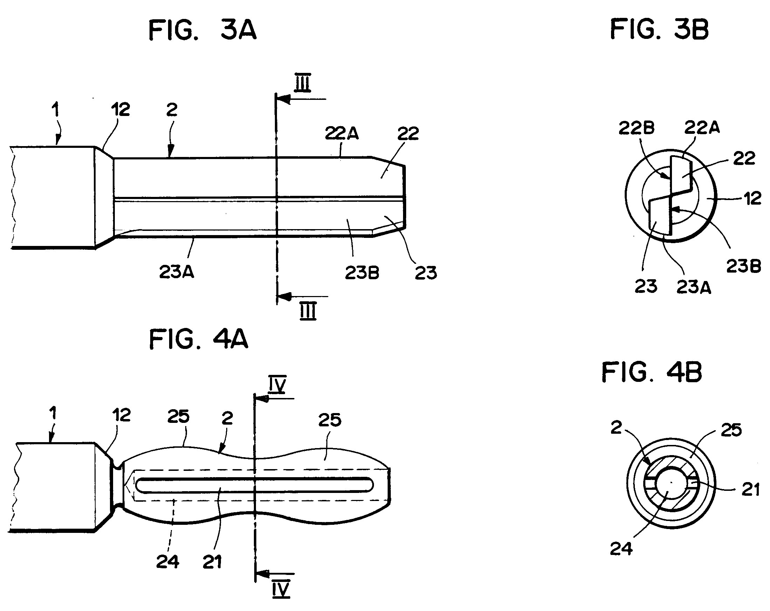

Les figures 3A et 3B représentent une troisième forme d'exécution d'une portion d'insertion 2. Dans ce cas, la portion d'insertion 2 est composée de deux lames 22 et 23 susceptibles de coulisser l'une à côté de l'autre le long d'un plan passant par deux faces latérales se faisant face 22B et 23B de chacune des lames 22 et 23, de la même manière que deux lames d'une paire de ciseaux. Comme on le voit à la figure 3B, et en se référant à une représentation trigonométrique, les lames 22 et 23 sont disposées dans deux quadrants opposés, par exemple le premier et le troisième. L'élasticité de la portion d'insertion sera obtenue dans ce cas par la flexion de chacune des lames 22 et 23 à son point d'attache contre la portion de contact 1. Afin d'augmenter cette élasticité, il sera donc possible de prévoir des évidements complémentaires (non représentés sur la figure) à proximité de ces points d'attache. Les surfaces d'appui 22A et 23A peuvent aussi être relativement rectilignes, comme sur la figure, ou présenter des ondulations comme décrit plus haut. De préférence elles se terminent par un biais ou un arrondi afin de faciliter l'insertion de la pièce dans le trou métallisé. Une telle pièce est aussi obtenue par un premier décolletage de la portion de contact 1, puis d'une portion cylindrique ou présentant des ondulations, suivie du fraisage des faces des lames 22 et 23 ainsi que des évidements éventuels.

La forme d'exécution de la portion d'insertion 2 visible sur les figures 4A et 4B est obtenue de manière assez semblable à celle relative aux figures 2A et 2B. Après décolletage de la portion de contact 1 ainsi que de la portion d'insertion 2, présentant aussi un certain nombre d'ondulations, il n'est procédé qu'à un fraisage traversant de la portion 2 pour créer la fente 21, semblable à celle décrite en regard de la première et de la deuxième forme d'exécution, ainsi qu'éventuellement à un perçage longitudinal depuis l'extrémité opposée à celle reliée à la portion de contact 1, afin de créer le trou borgne 24 dans la portion d'insertion, permettant un ajustement optimum de l'élasticité de ladite portion. Celle-ci présente, selon la représentation de cette forme d'exécution, deux protubérances 25 ayant une forme générale de boule. Il est bien entendu qu'il est aussi possible de n'avoir qu'une seule protubérance 25 ou davantage que deux, ceci dépendant essentiellement de l'épaisseur de la plaque de circuit imprimé. Dans ce cas, l'appui de la portion d'insertion 2 contre la paroi interne du trou métallisé est constitué d'un certain nombre de lignes quasi semi-circulaires, l'élasticité de ladite portion étant déterminée par la quantité de matière restant sur cette portion après usinage. Comme pour la deuxième forme d'exécution, celle-ci comporte en outre une élasticité longitudinale due aux faibles sections métalliques entre les protubérances 25; cet effet améliore le maintien de la pièce à l'intérieur du trou métallisé.

Toutes les formes d'exécution décrites ici d'une pièce de contact selon l'invention, ainsi que toutes les formes d'exécution possibles non décrites mais conformes aux caractéristiques des revendications répondent donc aux buts fixés initialement, soit d'obtenir une pièce de contact dont la fixation mécanique et le contact électrique dans un trou métallisé d'une plaque de circuit imprimé soient fiables dans le temps, ceci même après de nombreuses opérations d'insertion/retrait et dont l'usinage soit relativement aisé.

## Revendications

**1-**Pièce de contact comportant en particulier une portion de contact (1) et une portion d'insertion (2) reliées entre elles par une portion en forme de tronc de cône (12), caractérisée en ce que la portion de contact, la portion tronconique et la ou les surfaces d'appui (20A) de la portion d'insertion sont obtenues par décolletage, la portion d'insertion pouvant comporter en outre une partie (20B) obtenue par fraisage, et en ce que la ou les surfaces d'appui ne présentent aucune apérité ou décrochement brusque.

**2-**Pièce de contact selon la revendication 1, caractérisée en ce que la portion d'insertion comporte un évidement coaxial longitudinal (24) obtenu par décolletage ou perçage.

**3-**Pièce de contact selon l'une des revendications 1 ou 2, caractérisée en ce que la portion d'insertion comporte une partie centrale cylindrique faisant office de surface d'appui, décolletée selon un diamètre légèrement supérieur au diamètre intérieur d'un trou métallisé.

**4-**Pièce de contact selon l'une des revendications 1 ou 2, caractérisée en ce que la portion d'insertion comporte une partie centrale comportant au-moins une ondulation décolletée ayant un diamètre maximum légèrement supérieur au diamètre intérieur d'un trou métallisé.

**5-**Pièce de contact selon l'une des revendications 3 ou 4, caractérisée en ce que la portion d'insertion comporte une fente traversante (21) s'étendant sur une partie de la longueur de ladite portion d'insertion afin de créer deux cols de cygne élastiques, ladite fente étant obtenue par fraisage.

**6-**Pièce de contact selon la revendication 5, caractérisée en ce que la portion d'insertion comprend deux faces latérales (20B) obtenues par fraisage.

**7-**Pièce de contact selon l'une des revendications 3 ou 4, caractérisée en ce que la portion d'insertion comporte deux lames décalées (22,23) aptes à se croiser, les faces latérales (22b,23B) ainsi que les faces inférieures de chacune desdites lames étant obtenues par fraisage.
